Europäisches Patentamt

(19) European Patent Office

Office européen des brevets

(11) Veröffentlichungsnummer : **0 132 850**
**B1**

(12) **EUROPÄISCHE PATENTSCHRIFT**

(45) Veröffentlichungstag der Patentschrift :
11.02.87

(51) Int. Cl.⁴ : **H 03 K 17/945**

(21) Anmeldenummer : **84108888.3**

(22) Anmeldetag : **26.07.84**

(54) Selbstprüfender Näherungsschalter.

(30) Priorität : **28.07.83 DE 3327188**

(43) Veröffentlichungstag der Anmeldung :
**13.02.85 Patentblatt 85/07**

(45) Bekanntmachung des Hinweises auf die Patenterteilung : **11.02.87 Patentblatt 87/07**

(84) Benannte Vertragsstaaten :
**CH DE FR GB IT LI**

(56) Entgegenhaltungen :
**EP-A- 0 035 225**
**EP-A- 0 060 992**
**EP-A- 0 075 086**
**EP-A- 0 087 094**
**DE-B- 1 124 133**
**DE-C- 3 150 212**
**DE-C- 3 220 111**

(73) Patentinhaber : **Gebhard Balluff Fabrik feinmechanischer Erzeugnisse GmbH & Co.**
**Gartenstrasse 21**
**D-7303 Neuhausen a.d.F. (DE)**

(72) Erfinder : **Kammerer, Heinz**
**Achalmstrasse 29**
**D-7302 Ostfildern 2 (DE)**

(74) Vertreter : **Hoeger, Stellrecht & Partner**
**Uhlandstrasse 14c**
**D-7000 Stuttgart 1 (DE)**

## Beschreibung

Die Erfindung betrifft einen selbstprüfenden Näherungsschalter mit einem Oszillator, mit einem Demodulator, mit einer Triggerstufe, mit einer getakteten Prüfimpulsquelle, welche Prüfimpulse, deren positive und deren negative Amplitude ausreichend hoch ist, um unabhängig vom Schaltzustand der Triggerstufe jeweils für die Dauer eines Einzelimpulses ein Kippen derselben in den jeweils anderen Schaltzustand derselben herbeizuführen, an den Oszillator zum Simulieren einer Ent- oder Bedämpfung desselben anlegt, und mit einer auf die in Abhängigkeit von den Prüfimpulsen auftretenden Pegeländerungen des Ausgangssignals der Triggerstufe ansprechenden, der Erzeugung eines Prüfausgangssignals dienenden Prüfschaltung.

Ein selbstprüfender Näherungsschalter ist bereits aus der EP-OS 0 035 225 bekannt. Bei dem bekannten Näherungsschalter begnügt man sich damit, die einwandfreie Funktion des Näherungsschalters dadurch zu überprüfen, daß man bei entdämpftem bzw. frei schwingendem Oszillator überprüft, ob sich der Oszillator mit Hilfe eines Prüfimpulses bedämpfen lässt bzw. ob sich die Schwingungsamplitude des Oszillators durch das Anlegen eines Prüfimpulses in ähnlicher Weise gegebenenfalls bis auf Null verringern lässt, wie bei der Annäherung eines zu erfassenden Elementes an die aktive Fläche des Näherungsschalters.

Diese Art der Funktionsprüfung verhindert im Prinzip die Erkennung von Fehlern, die dazu führen, daß das Ausgangssignal des Näherungsschalters einen bedämpften Zustand des Oszillators anzeigt, obwohl der Oszillator in Wirklichkeit nicht durch ein an die aktive Fläche des Näherungsschalters ausreichend weit herangeführtes Element bedämpft wird. Dieser Nachteil wird bei dem Näherungsschalter gemäß der DE-OS 30 07 929 überwunden, wo zusätzlich die Möglichkeit besteht, den Oszillator zu Prüfzwecken zu entdämpfen. Bei den bekannten Näherungsschaltern werden jeweils die internen Betriebsparameter des Oszillators beeinflusst, um durch diese interne Beeinflussung eine Änderung der Oszillatorschwingung zu bewirken, die einer bestimmten Lageänderung eines den Schwingkreis von außen beeinflussenden Elements, z. B. eines Schaltnockens, entspricht. In diesem Sinne wird eine externe Be- oder Entdämpfung durch interne Beeinflussung der internen Betriebsparameter simuliert, wobei stets mit sogenannten Abreißoszillatoren gearbeitet wird, bei denen die Schwingung bei externer oder interner Bedämpfung abreißt.

Ausgehend vom Stand der Technik liegt der Erfindung die Aufgabe zugrunde, unabhängig vom Schwingungszustand des Oszillators, d. h. sowohl bei bedämpftem als auch bei entdämpftem Oszillator, eine Funktionsprüfung des Näherungsschalters ohne eine Beeinflussung der internen Betriebsparameter des Oszillators durchführen zu können.

Diese Aufgabe wird bei einem selbstprüfenden Näherungsschalter der eingangs angegebenen Art gemäß der Erfindung dadurch gelöst, daß der Oszillator als analog arbeitender Oszillator mit einer in Abhängigkeit von einer Bedämpfung stetig veränderbaren Schwingungsamplitude ausgebildet ist und daß die Prüfimpulse der Prüfimpulsquelle in Form bipolarer Doppelimpulse an einen Anschluß des Oszillators anlegbar sind, an dem sie der Speisespannung und/oder dem Speisestrom des Oszillators überlagerbar sind.

Die Erfindung basiert auf dem Grundgedanken, daß es mit Hilfe von Prüfimpulsen in Form von bipolaren Doppelimpulsen an einem Speisespannungsanschluß des Oszillators möglich ist, je nach dem Schwingungszustand des Oszillators und dem entsprechenden Schaltzustand der Triggerstufe entweder mit dem positiven Einzelimpuls oder mit dem negativen Einzelimpuls des Doppelimpulses eine signifikante Änderung der Amplitude der Oszillatorschwingung herbeizuführen und so auf jeden Fall am Ausgang der Triggerstufe einen Signalwechsel zu bewirken. Diese Signalwechsel am Ausgang der Triggerstufe werden dann mit Hilfe einer Prüfschaltung ausgewertet, die folglich nur dann ein Ausgangssignal erzeugt, welches eine einwandfreie Funktion des Näherungsschalters anzeigt, wenn die Prüfimpulse tatsächlich Signalwechsel am Ausgang der Triggerstufe herbeiführen. Dieses Arbeitsprinzip bringt den wesentlichen Vorteil mit sich, daß die Funktion des Näherungsschalters kontinuierlich und unabhängig davon überprüft werden kann, ob der Schwingkreis gerade bedämpft ist oder nicht. Dabei treten die Amplitudenänderungen in Abhängigkeit von den Prüfimpulsen sehr schnell ein, so daß mit kürzeren Prüfimpulsen gearbeitet werden kann als bei Abreißoszillatoren, wo insbesondere das Wiederanschwingen nach einer Bedämpfung eine erhebliche Zeit beansprucht.

Außerdem ist es möglich, die Amplitude der Prüfimpulse sehr exakt an die Amplitudenänderung der Oszillatorschwingung in dem kritischen Bereich anzupassen, so daß eine Störung bereits dann festgestellt und angezeigt werden kann, wenn die Betriebsparameter der Schaltkreise des Näherungsschalters außerhalb eines vorgegebenen Toleranzbereichs liegen.

Als günstig hat es sich auch erwiesen, wenn die Prüfschaltung des erfindungsgemäßen Näherungsschalters als aktive Verstärkerschaltung ausgebildet ist, da in diesem Fall auch Fehler in der Prüfschaltung selbst sofort erkannt werden können. Als bevorzugte aktive Verstärkerschaltung hat sich dabei die sogenannte Stromquellenschaltung erwiesen.

Weiterhin hat es sich als vorteilhaft erwiesen, wenn die Prüfschaltung selbst induktiv an den Ausgang der Triggerstufe angekoppelt ist, wodurch verhindert wird, daß beispielsweise bei einer Störung in der Triggerschaltung ein Dauersignal an die Prüfschaltung gelangt, welches an deren Ausgang eine einwandfreie Funktion des Näherungsschalters vortäuscht.

In entsprechender Weise hat es sich auch als günstig erwiesen, wenn die Prüfimpulsquelle induktiv oder kapazitiv an den Eingang des Oszillators angekoppelt ist, um auch hier die Übertragung von Dauersignalen zu verhindern, die aufgrund einer Funktionsstörung, wie z. B. eines Kurzschlusses oder einer Unterbrechung auftreten können.

Erfindungsgemäß wird die Dauer der Prüfimpulse vorzugsweise so gewählt, daß sie kürzer ist als die Ansprechzeit der von den Ausgangssignalen des Näherungsschalters gesteuerten Schalteinrichtungen, so daß am Signalausgang des Näherungsschalters keine durch die Prüfimpulse bewirkten Signalwechsel wirksam werden. Vorzugsweise kann die Dauer der Prüfimpulse kleiner als 0,5 ms sein, was bei Verwendung von Relais als Schalteinrichtungen kurz genug ist, um ein Ansprechen der Relais zu verhindern. Gegebenenfalls kann aber auch mit längeren Prüfimpulsen gearbeitet werden, deren Wirksamkeit am Ausgang durch entsprechende Zeitglieder unterdrückt wird.

Als günstig hat sich bezüglich der Prüfimpulse ferner eine Impulsfolgefrequenz von etwa 200 Hz erwiesen, da eine entsprechende Impulsfolge am Ausgang der Triggerstufe mittels einer technisch einfach zu realisierenden Prüfschaltung erfasst werden kann, an deren Eingang ein Kondensator liegt.

Besonders vorteilhaft ist es, wenn die Amplitude der positiven und der negativen Einzelimpulse der Prüfimpulse derart gewählt ist, daß bei jedem Arbeitspunkt der Triggerstufe die von diesem Arbeitspunkt jeweils weiter entfernte Schaltschwelle gerade noch überschreitbar ist. Aufgrund dieser Ausgestaltung ist es nämlich möglich, allmähliche Änderungen der Betriebsparameter des Oszillators und/oder der Triggerstufe, die zu außerhalb eines vorgegebenen Toleranzbereiches liegenden Signalen führen, frühzeitig zu erfassen. Besonders günstig ist es dabei, wenn die positive und die negative Amplitude der Einzelimpulse der Prüfimpulse exakt der Amplitudenänderung bei Bedämpfung des Oszillators durch einen dem Näherungsschalter zugeordneten Schaltnocken entspricht, da in diesem Fall die Möglichkeit besteht, anhand des Ausgangssignals der Prüfschaltung gleichzeitig zu überprüfen, ob der vorgegebene Ansprechabstand des Näherungsschalters noch eingehalten wird oder nicht.

Weitere Einzelheiten und Vorteile der Erfindung werden nachstehend anhand von Zeichnungen noch näher erläutert. Es zeigen :

Figur 1 ein Blockschaltbild mit den wesentlichen Baugruppen eines selbstprüfenden Näherungsschalters gemäß der Erfindung ;

Figur 2 ein detaillierteres Schaltbild eines selbstprüfenden Näherungsschalters gemäß der Erfindung und

Figur 3 ein Diagramm zur Erläuterung der Arbeitsweise eines erfindungsgemäßen Näherungsschalters.

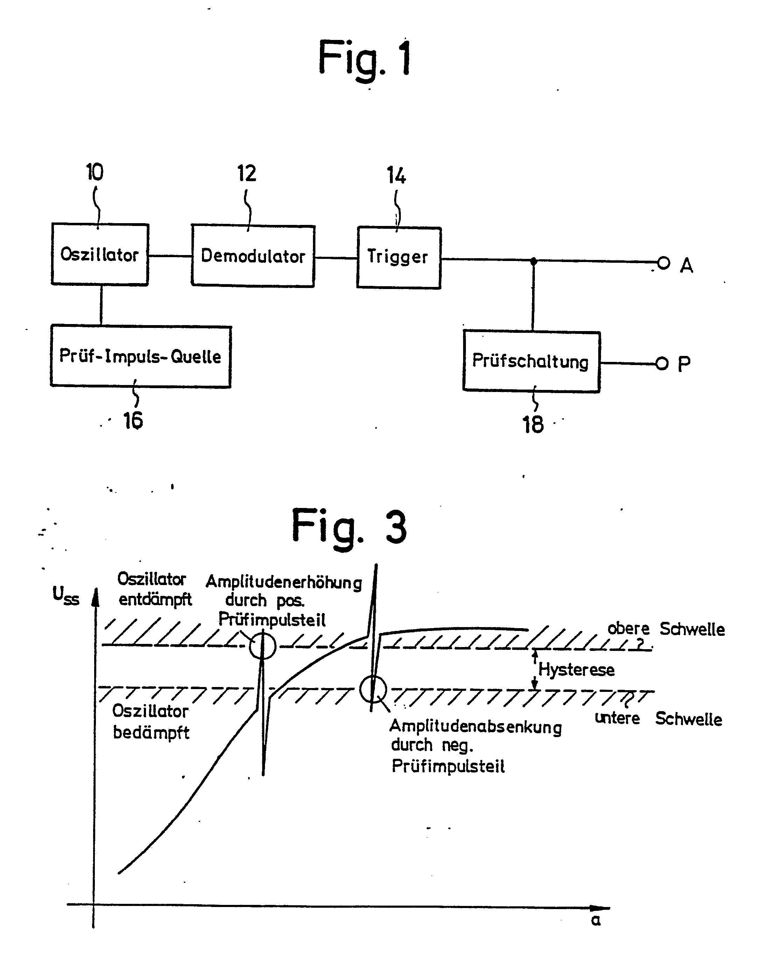

Im einzelnen zeigt Fig. 1 einen Oszillator 10, dessen Ausgang mit einem Demodulator 12 verbunden ist, an dessen Ausgang eine Triggerstufe 14 angeschlossen ist.

Diese drei Schaltkreise 10, 12, 14 bilden die üblichen Schaltkreise eines Näherungsschalters und werden normalerweise noch durch einen Verstärker am Ausgang der Triggerstufe 14 ergänzt, um am Ausgang A des Näherungsschalters ein Signal zu erhalten, dessen Leistung ausreicht, um beispielsweise Relais unmittelbar zu betätigen. Gemäß der Erfindung ist zusätzlich eine Prüfimpulsquelle 16 vorgesehen, die mit dem Oszillator 10 verbunden ist. Außerdem ist eine Prüfschaltung 18 vorgesehen, welche an den Ausgang der Triggerstufe 14 angeschlossen ist und als Ausgang einen Prüfausgang P aufweist, dessen Signalpegel anzeigt, ob der Näherungsschalter einwandfrei arbeitet oder nicht.

Bei dem Näherungsschalter gemäß Fig. 1 werden der Speisespannung bzw. dem Speisestrom des Oszillators 10 aus der Prüfimpulsquelle 16 stammende Prüfimpulse überlagert, die als bipolare Doppelimpulse ausgebildet sind, derart, daß von den beiden Einzelimpulsen jedes Prüfimpulses der Einzelimpuls der einen Polarität ein Absinken der Amplitude der Oszillatorschwingung bewirkt, während der andere Einzelimpuls eine Erhöhung der Amplitude der Oszillatorschwingung bewirkt. Das Ausgangssignal des Oszillators wird in dem Demodulator 12 demoduliert bzw. gleichgerichtet und an den Eingang der Triggerstufe 14 angelegt, deren Schaltschwellen so gewählt sind, daß ihr Ausgangssignal, solange am Oszillator kein Prüfimpuls anliegt, bei bedämpftem Oszillator einen ersten Pegel und bei entdämpftem Oszillator einen zweiten Pegel besitzt. Diese Signalpegel stehen — gegebenenfalls nach einer Verstärkung — am Ausgang A des Näherungsschalters zur Verfügung, um nachgeschaltete Schalteinrichtungen, insbesondere Relais-Schalteinrichtungen in üblicher Weise zu betätigen.

Durch die von der Prüfimpulsquelle 16 gelieferten Prüfimpulse wird erfindungsgemäß erreicht, daß das Ausgangssignal des Oszillators derart verändert wird, daß die Triggerstufe bei jedem Prüfimpuls ihren Schaltzustand unabhängig davon ändert, welchen ihrer beiden Schaltzustände sie aufgrund der tatsächlichen Bedämpfung oder Entdämpfung zunächst einnimmt. Erfindungsgemäß werden dabei die durch die Prüfimpulse verursachten Änderungen des Schaltzustandes am Ausgang der Triggerstufe 14 so kurz gewählt, daß die nachgeschalteten Schalteinrichtungen nicht auf die kurzfristigen Pegeländerungen am Ausgang der Triggerstufe 14 ansprechen. Diese kurzfristigen bzw. impulsförmigen Pegeländerungen am Ausgang der Triggerstufe werden jedoch von der Prüfschaltung 18 erfasst, die dann, wenn innerhalb eines vorgegebenen Zeitintervalls keine Pegeländerung am Ausgang der Triggerstufe auftritt, an ihrem Prüfausgang P ein Signal liefert, welches eine Funktionsstörung des Näherungsschalters anzeigt.

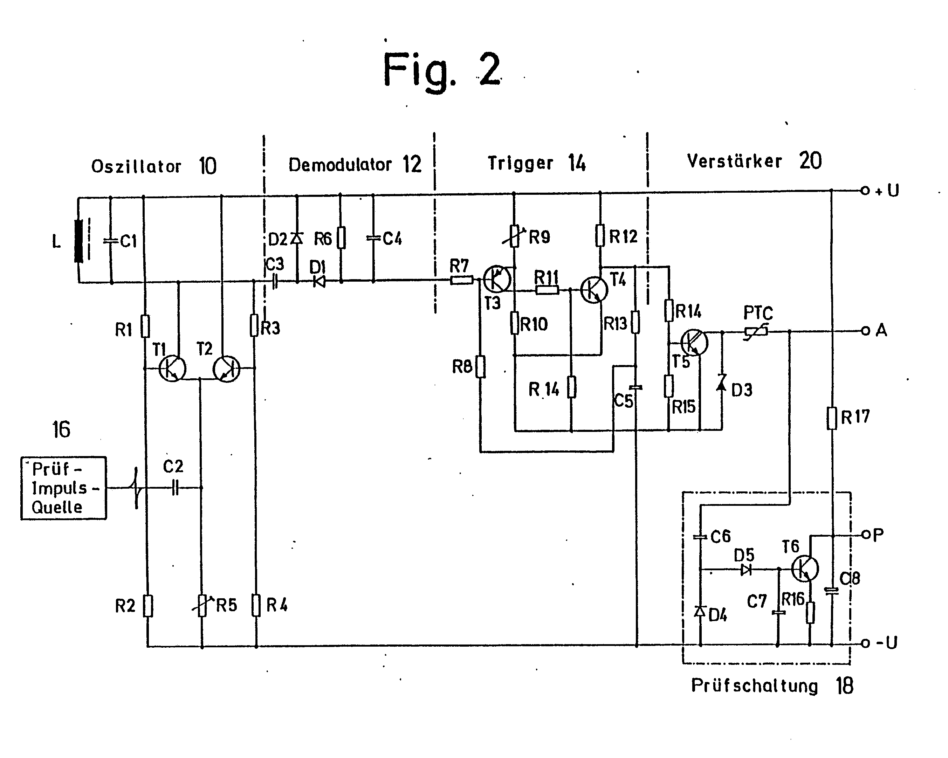

Die Funktion des erfindungsgemäßen Näherungsschalters, welche vorstehend allgemein erläutert wurde, soll nachstehend anhand des Schaltbilds gemäß Fig. 2 noch näher erläutert werden. Wie Fig. 2 zeigt, ist der Oszillator 10 gemäß einem bevorzugten Ausführungsbeispiel der Erfindung als analog arbeitender Oszillator ausgebildet, der an die beiden Pole einer Speisespannungsquelle (nicht dargestellt) angeschlossen ist, welche eine positive Spannung + U und eine (relativ dazu) negative Spannung — U liefert. Der Oszillator 10 ist beim Ausführungsbeispiel, welches einen induktiven Näherungsschalter betrifft, in bekannter Weise mit einer Induktivität L, einem ersten Kondensator C1, zwei npn-Transistoren T1, T2 und fünf Widerständen R1 bis R5 aufgebaut, von denen der Widerstand R5 als einstellbarer Widerstand bzw. als Potentiometer ausgebildet ist. Ein Oszillator 10 des betreffenden Typs ist in der Firmendruckschrift « Integrated Circuit Design — Manual; Linear-Interdesign » der Firma Ferranti vom August 1980 beschrieben.

Die Prüfimpulsquelle 16 ist gemäß Fig. 2 über einen Kondensator C2 an den gemeinsamen Verbindungspunkt der Emitter der beiden Transistoren T1 und T2 angekoppelt. Die Prüfimpulsquelle 16 ist so ausgebildet, daß sie, wie in der Zeichnung am Ausgang der Prüfimpulsquelle angedeutet, steile und relativ kurze bipolare Doppelimpulse liefert. Diese Doppelimpulse werden dem Ausgangssignal des Oszillators 10 direkt überlagert, wie dies aus Fig. 3 deutlich wird, wo die Oszillatorspannung $U_{ss}$ über dem Abstand a eines Schaltnockens von der aktiven Fläche des Näherungsschalters dargestellt ist. Das Ausgangssignal des Oszillators 10 mit den überlagerten Prüfimpulsen wird in dem Demodulator 12, welcher in üblicher Weise aus zwei Kondensatoren C3, C4, zwei Dioden D1, D2 und einem Widerstand R6 aufgebaut ist, gleichgerichtet und an den Eingang der Triggerstufe 14 gelegt. Auch die Triggerstufe 14 ist in üblicher Weise aus zwei Transistoren T3, T4 und mehreren Widerständen R7 bis R14 sowie einem Kondensator C5 aufgebaut. Dabei lassen sich die Schaltschwellen an dem einstellbaren Widerstand R9 einstellen, während C5 die Aufrechterhaltung der Hysterese der Triggerstufe 14 gewährleistet. Der Ausgang der Triggerstufe 14, nämlich der Kollektor des Transistors T4, ist mit dem Verstärker 20 verbunden, der einen Leistungstransistor T5 (Darlington-Schaltung) mit einem Basisspannungsteiler aus zwei Widerständen R14 und R15 und eine parallel zur Kollektor-Emitter-Strecker des Transistors T5 geschaltete Zener-Diode D3 aufweist, wobei der Kollektor des Transistors T5 zum Kurzschlußschutz mit dem Ausgang A über einen temperaturabhangigen Widerstand PTC (*) mit positivem Tempera-

*) (Kaltleiter) turkoeffizienten verbunden ist. Beim Ausführungsbeispiel liegt in der mit dem Ausgang A verbundenen Eingangsleitung der Prüfschaltung 18 ein Kondensator C6, dessen vom Ausgang A abgewandte Elektrode über eine erste Diode D4 mit dem negativen Pol — U der Speisespannungsquelle und über eine zweite Diode D5 mit der Basis eines Ausgangstransistors T6 verbunden ist, wobei die Basis des Transistors T6 über einen Kondensator C7 mit dem negativen Pol — U verbunden ist, wobei der Emitter des Transistors T6 über einen Widerstand R16 ebenfalls mit dem negativen Pol — U verbunden ist, und wobei parallel zur Kollektor-Emitter-Strecke des Transistors T6 ein relativ großer Kondensator, beispielsweise mit einer Kapazität von 1 μF, liegt, der mit dem Bezugszeichen C8 bezeichnet ist. Man erkennt, daß der Transistor T6 der Prüfschaltung durch positive Schaltflanken am Ausgang des Verstärkers 20 leitend gesteuert und und dabei im wesentlichen die negative Spannung — U an die mit dem Prüfausgang P verbundene Platte des Kondensators C8 legt, an der bei gesperrtem Transistor T6 über einen mit dem positiven Pol + U der Speisespannungsquelle verbundenen Widerstand R17 die positive Spannung + U auftritt, wenn der Transistor T6 der Prüfschaltung 18 während eines vorgegebenen Zeitintervalls, welches durch das RC-Glied R17, C8 bestimmt wird, kein Durchsteuern des Transistors T6 in den leitfähigen Zustand erfolgt, was als Fehlfunktion der Schaltung ausgewertet wird.

Aus der vorstehenden Beschreibung wird deutlich, daß die von der Prüfimpulsquelle erzeugten Doppelimpulse derart an einen entsprechenden Anschluß des Oszillators angelegt werden bzw. in diesen eingekoppelt werden, daß sie dem an dem betreffenden Anschluß fließenden Strom bzw. der an dem betreffenden Anschluß herrschenden Spannung überlagert werden. Dabei kann beispielsweise die Speisespannung für den Oszillator kurzfristig gegenüber der normalen Spannung auf einen höheren und auf einen niedrigeren Pegel geschaltet werden, um so einen entsprechenden Doppelimpuls zu erzeugen. Gegebenenfalls kann auch eine kombinierte Überlagerung des Speisestroms und der Speisespannung mit Doppelimpulsen aus der Prüfimpulsquelle erfolgen. Auf jeden Fall wird gemäß der Erfindung durch die Prüfimpulse keine Zu- oder Abschaltung von Widerständen im Oszillator herbeigeführt, wie dies bisher zur Simulation einer Be- oder Entdämpfung üblich war. Die inneren Parameter des Oszillators, die durch die bisher zu- bzw. abgeschalteten Widerstände mit bestimmt werden, werden also nicht beeinflusst, vielmehr werden die als Prüfimpulse dienenden Doppelimpulse an einer bestimmten Stelle auf den dort fließenden Strom bzw. auf die dort herrschende Spannung « aufgesetzt », ohne daß hierdurch die inneren Parameter des Oszillators beeinflusst würden.

Besonders vorteilhaft ist es, wenn die Einkopplung der Doppelimpulse über eine Stromspiegelschaltung erfolgt, wie sie aus der JC-Technik bekannt ist.

**Patentansprüche**

1. Selbstprüfender Näherungsschalter mit einem Oszillator (10), mit einem Demodulator (12), mit einer Triggerstufe (14), mit einer getakteten Prüfimpulsquelle (16), welche Prüfimpulse, deren positive und deren negative Amplitude ausreichend hoch ist, um unabhängig vom Schaltzustand der Triggerstufe jeweils für die Dauer eines Einzelimpulses ein Kippen derselben in den jeweils anderen Schaltzustand derselben herbeizuführen, an den Oszillator zum Simulieren einer Ent- oder Bedämpfung desselben anlegt, und mit einer auf die in Abhängigkeit von den Prüfimpulsen auftretenden Pegeländerungen des Ausgangssignals der Triggerstufe ansprechenden, der Erzeugung eines Prüfausgangssignals dienenden Prüfschaltung (18), dadurch gekennzeichnet, daß der Oszillator (10) als analog arbeitender Oszillator mit einer in Abhängigkeit von einer Bedämpfung stetig veränderbaren Schwingungsamplitude ausgebildet ist und daß die Prüfimpulse der Prüfimpulsquelle (16) in Form bipolarer Doppelimpulse an einen Anschluß des Oszillators (10) anlegbar sind, an dem sie der Speisespannung und/oder dem Speisestrom des Oszillators (10) überlagerbar sind.

2. Näherungsschalter nach Anspruch 1, dadurch gekennzeichnet, daß die Prüfschaltung (18) als aktive Verstärkerschaltung ausgebildet ist.

3. Näherungsschalter nach Anspruch 2, dadurch gekennzeichnet, daß die Prüfschaltung (18) induktiv an den Ausgang der Triggerstufe (14) angekoppelt ist.

4. Näherungsschalter nach Anspruch 2 oder 3, dadurch gekennzeichnet, daß die Prüfschaltung (18) als Stromquellenschaltung ausgebildet ist.

5. Näherungsschalter nach einem der Ansprüche 1 bis 4, dadurch gekennzeichnet, daß die Prüfimpulsquelle (16) zur kapazitiven Einkoppelung der Prüfimpulse an den Oszillator (10) über eine Kapazität (C2) angekoppelt ist.

6. Näherungsschalter nach einem der Ansprüche 1 bis 4, dadurch gekennzeichnet, daß die Prüfimpulsquelle (16) zur induktiven Einkoppelung der Prüfimpulse induktiv an den Oszillator (10) angekoppelt ist.

7. Näherungsschalter nach einem der Ansprüche 1 bis 6, dadurch gekennzeichnet, daß die Dauer der Prüfimpulse kürzer ist als die Ansprechzeit der von den Ausgangssignalen des Näherungsschalters gesteuerten Schalteinrichtungen.

8. Näherungsschalter nach Anspruch 7, dadurch gekennzeichnet, daß die Dauer der Prüfimpulse kleiner als 0,5 ms ist.

9. Näherungsschalter nach einem der Ansprüche 1 bis 8, dadurch gekennzeichnet, daß die Impulsfolgefrequenz der Prüfimpulse etwa 200 Hz beträgt.

10. Näherungsschalter nach einem der Ansprüche 1 bis 9, dadurch gekennzeichnet, daß die Amplitude der positiven und der negativen Einzelimpulse der Prüfimpulse derart gewählt ist, daß bei jedem Arbeitspunkt der Triggerstufe (14) die von diesem Arbeitspunkt jeweils weiter entfernte Schaltschwelle der Triggerstufe (14) gerade noch überschreitbar ist.

11. Näherungsschalter nach Anspruch 10, dadurch gekennzeichnet, daß die positive und die negative Amplitude der Einzelimpulse der Prüfimpulse exakt der Amplitudenänderung bei Bedämpfung des Oszillators (10) durch einen dem Näherungsschalter zugeordneten Schaltnocken entspricht.

12. Näherungsschalter nach einem der Ansprüche 1 bis 11, dadurch gekennzeichnet, daß die Prüfschaltung (18) als bistabile Schaltstufe mit zwei antivalenten Ausgängen ausgebildet ist.

13. Näherungsschalter nach einem der Ansprüche 1 bis 11, dadurch gekennzeichnet, daß die Prüfschaltung (18) derart ausgebildet ist, daß das Signal am Prüfausgang (P) bei störungsfreiem Betrieb jeweils antivalent zum Signal am Ausgang (A) des Näherungsschalters ist.

14. Näherungsschalter nach einem der Ansprüche 1 bis 13, dadurch gekennzeichnet, daß die Prüfschaltung (18) räumlich als Bestandteil des Näherungsschalters selbst vorgesehen ist.

15. Näherungsschalter nach einem der Ansprüche 1 bis 13, dadurch gekennzeichnet, daß die Prüfschaltung (18) als Bestandteil der von dem Näherungsschalter gesteuerten Schalteinrichtungen ausgebildet und räumlich von den Schaltkreisen des Näherungsschalters selbst getrennt ist.

**Claims**

1. A self-testing proximity switch comprising an oscillator (10), a demodulator (12), a trigger stage (14), a test pulse source (16) for applying clocked test pulses to the oscillator to simulate a damping or non-damping thereof, the positive and negative amplitudes of said pulses being sufficiently high so that, independent of the respective switching state of the strigger stage, said trigger stage is caused to switch over to the other switching state for the duration of a single pulse, and also comprising a test circuit (18) responsive to level changes in the output signal from the trigger stage, said changes occurring as a function of the test pulses, and serving to generate a test output signal, characterized in that the oscillator (10) is designed as an analogously operating oscillator having an amplitude of oscillation constantly varying in response to damping and that the test pulses of the test pulse source (16) are applied to a connection of the oscillator (10) in the form of double bipolar pulses adapted to be superimposed on the supply voltage and/or the supply current of the oscillator (10) at said connection.

2. Proximity switch as defined in claim 1, characterized in that the test circuit (18) is designed as an active amplifier circuit.

3. Proximity switch as defined in claim 2, characterized in that the test circuit (18) is inductively coupled to the output of the trigger stage (14).

4. Proximity switch as defined in claim 2 or claim 3, characterized in that the test circuit (18) is designed as a current source circuit.

5. Proximity switch as defined in any of claims 1 to 4, characterized in that the test pulse source (16) is coupled to the oscillator (10) via a capacitor (C2) for capacitive coupling in of the test pulses.

6. Proximity switch as defined in any of claims 1 to 4, characterized in that the test pulse source (16) is inductively coupled to the oscillator (10) for inductive coupling in of the test pulses.

7. Proximity switch as defined in any of claims 1 to 6, characterized in that the duration of the test pulses is shorter than the response time of the switching means controlled by the output signals of the proximity switch.

8. Proximity switch as defined in claim 7, characterized in that the duration of the test pulses is less than 0.5 ms.

9. Proximity switch as defined in any of claims 1 to 8, characterized in that the pulse recurrence frequency of the test pulses is approximately 200 Hz.

10. Proximity switch as defined in any of claims 1 to 9, characterized in that the amplitude of the individual positive and negative pulses of the test pulses is selected such that at each operating point of the trigger stage (14) the switching threshold of the trigger stage (14) further removed from said operating point is just exceeded.

11. Proximity switch as defined in claim 10, characterized in that the positive and negative amplitude of the individual pulses of the test pulses exactly corresponds to the change in amplitude during damping of the oscillator (10) by a trigger cam associated with the proximity switch.

12. Proximity switch as defined in any of claims 1 to 11, characterized in that the test circuit (18) is designed as a bistable switching step comprising two antivalent outputs.

13. Proximity switch as defined in any of claims 1 to 11, characterized in that the test circuit (18) is designed such that the signal at the test output (P) is antivalent to the signal at the output (A) of the proximity switch during interference-free operation.

14. Proximity switch as defined in any of claims 1 to 13, characterized in that the test circuit (18) is provided spatially as a component part of the proximity switch itself.

15. Proximity switch as defined in any of claims 1 to 13, characterized in that the test circuit (18) is designed as a component part of the switching means controlled by the proximity switch and is spatially separated from the circuits of the proximity switch itself.

**Revendications**

1. Commutateur de proximité autocontrôlé comportant un oscillateur (10), un démodulateur (12), un basculeur (14), une source (16) d'impulsions de contrôle cycliques qui applique à l'oscillateur, pour simuler une compensation de l'amortissement ou un amortissement, des impulsions de contrôle dont l'amplitude positive et l'amplitude négative sont suffisamment élevées pour provoquer, indépendamment de l'état de commutation du basculeur, un basculement de celui-ci dans l'autre position de commutation et ce pendant la durée d'une impulsion simple, ainsi qu'un circuit de contrôle (18) intervenant à la suite de variations de niveau du signal de sortie du basculeur, survenant en fonction des impulsions de contrôle, et servant à produire un signal de sortie de contrôle, caractérisé en ce que l'oscillateur (10) est un oscillateur fonctionnant de manière analogique avec une amplitude d'oscillation variant constamment en fonction d'un amortissement, et en ce que les impulsions de contrôle de la source (16) sont applicables, sous la forme d'impulsions doubles bipolaires, à une sortie de l'oscillateur (10) où elles sont superposables à la tension d'alimentation et/ou au courant d'alimentation de l'oscillateur (10).

2. Commutateur de proximité selon la revendication 1, caractérisé en ce que le circuit de contrôle (18) est un circuit actif d'amplification.

3. Commutateur de proximité selon la revendication 2, caractérisé en ce que le circuit de contrôle (18) est couplé de manière inductive à la sortie du basculateur (14).

4. Commutateur de proximité selon la revendication 2 ou 3, caractérisé en ce que le circuit de contrôle (18) est un circuit de source de courant.

5. Commutateur de proximité selon l'une des revendications 1 à 4, caractérisé en ce que la source d'impulsions de contrôle (16) est couplée à l'oscillateur (10) par l'intermédiaire d'une capacité (C2) pour un couplage capacitif des impulsions de contrôle.

6. Commutateur de proximité selon l'une des revendications 1 à 4, caractérisé en ce que la source (16) d'impulsions de contrôle est couplée de manière inductive à l'oscillateur (10) pour un couplage inductif des impulsions de contrôle.

7. Commutateur de proximité selon l'une des revendications 1 à 6, caractérisé en ce que la durée des impulsions de contrôle est inférieure au temps de réponse des dispositifs de commutation commandés par les signaux de sortie du commutateur de proximité.

8. Commutateur de proximité selon la revendication 7, caractérisé en ce que la durée des impulsions de contrôle est inférieure à 0,5 ms.

9. Commutateur de proximité selon l'une des revendications 1 à 8, caractérisé en ce que la fréquence de répétition des impulsions de contrôle est d'environ 200 Hz.

10. Commutateur de proximité selon l'une des revendications 1 à 9, caractérisé en ce que l'amplitude de chacune des impulsions positive et négative des impulsions de contrôle est choisie de telle sorte qu'en tout point de travail du basculeur (14), le seuil de commutation de celui-ci, le plus éloigné de ce point de travail, peut encore être franchi.

11. Commutateur de proximité selon la revendication 10, caractérisé en ce que l'amplitude positive et négative de chacune des impulsions de contrôle correspond exactement à la variation d'amplitude en cas d'amortissement de l'oscillateur (10) par une came de commutation associée au commutateur de proximité.

12. Commutateur de proximité selon l'une des revendications 1 à 11, caractérisé en ce que le circuit de contrôle (18) est un élément de commutation bistable à deux sorties à anticoïncidence.

13. Commutateur de proximité selon l'une des revendications 1 à 11, caractérisé en ce que le circuit de contrôle (18) est conçu de telle sorte que le signal à la sortie de contrôle (P) ne coïncide pas dans tous les cas avec le signal de la sortie (A) du commutateur de proximité, dans le cas d'un fonctionnement non défectueux.

14. Commutateur de proximité selon l'une des revendications 1 à 13, caractérisé en ce que le circuit de contrôle (18) fait partie intégrante dans l'espace du commutateur de proximité lui-même.

15. Commutateur de proximité selon l'une des revendications 1 à 13, caractérisé en ce que le circuit de contrôle (18) fait partie intégrante des dispositifs de commutation commandés par le commutateur de proximité et est séparé dans l'espace des circuits du commutateur de proximité lui-même.

# Fig. 1

10        12        14

| Oszillator | — | Demodulator | — | Trigger | — | ○ A |

| Prüf-Impuls-Quelle |
16

| Prüfschaltung | ○ P |
18

# Fig. 3

$U_{SS}$

Oszillator entdämpft    Amplitudenerhöhung durch pos. Prüfimpulsteil

obere Schwelle

Hysterese

Oszillator bedämpft

Amplitudenabsenkung durch neg. Prüfimpulsteil

untere Schwelle

a

# Fig. 2

Oszillator 10    Demodulator 12    Trigger 14    Verstärker 20

Prüfschaltung 18

Prüf-Impuls-Quelle 16

+U    A    P    −U

L, C1, R1, R2, R3, R4, R5, T1, T2, C2, D2, C3, R6, D1, C4, R7, R9, R11, R10, R8, R12, T3, T4, R13, R14, C5, R14, T5, R15, PTC, D3, R17, C6, D5, T6, R16, C7, C8, D4